# EUROPEAN PATENT APPLICATION

(11) **EP 4 738 679 A1**
(43) Date of publication of application: **06.05.2026**
(21) Application number: 24838414.1
(22) Date of filing: 09.05.2024
(51) Int. Cl.: H02M 7/02, H02M 1/00, H05K 7/20, H02J 7/00, H02J 7/02

(54) **POWER CONVERSION MODULE AND VEHICLE-MOUNTED CHARGER APPLYING SAME**

(30) Priority: 07.07.2023 CN 202310831972
(71) Applicant: SHENZHEN VMAX NEW ENERGY (GROUP) CO., LTD, Shenzhen, Guangdong 518000 (CN)
(72) Inventor: FENG, Yingying, Shenzhen, Guangdong 518000 (CN); LUO, Yaowen, Shenzhen, Guangdong 518000 (CN); WANG, Guang, Shenzhen, Guangdong 518000 (CN); HE, Yao, Shenzhen, Guangdong 518000 (CN)
(74) Representative: Santarelli
(86) International application number: PCT/CN2024/091997
(87) International publication number: WO 2025/011155

(57) **Abstract**

The present invention provides a power conversion module and a vehicle charger using same. The power conversion module includes: a casing , and a spatial water channel, a power mainboard, an input terminal, a signal terminal, a LVDC terminal, and an output terminal each disposed on the casing, wherein the input terminal, the signal terminal, the LVDC terminal, and the output terminal are arranged on the same side of the casing, and the input terminal and the output terminal are respectively at two ends on the same side of the casing opposite to each other; and further comprises: an input filtering circuit board and an output filtering circuit board, wherein the input filtering circuit board and the output filtering circuit board are respectively arranged on two adjacent sides of the casing where the input terminal and the output terminal are disposed, and are electrically connected to the input terminal and the output terminal, respectively; the power mainboard is disposed at the top of the casing and electrically connected respectively to the input filtering circuit board and the output filtering circuit board. In the present invention, by way of dividing the filtering mainboard into an input filtering circuit board and an output filtering circuit board with high integration and small size, and arranging all terminals and nozzles on the same side of the casing, it is possible to improve the overall power density and optimize heat dissipation and electrical distribution.

## Description

### Technical Field

The present invention relates to the technical field of charging vehicles and power conversion, in particular to a power conversion module and an on-board charger using same.

### Background of the Invention

As a demand for energy conservation, emission reduction, and air pollution control is steadily on the increase, the motor industry needs to transform product's energy structure as soon as possible to achieve the goal of "carbon peaking" and "carbon neutrality". Currently, new energy vehicles are gradually being commercialized in the market, and electric vehicles are a mainstream model among them, which has huge potential for future development and market demand. Power conversion modules serving as an important component of an electric vehicle charging system (including EV charging piles, on-board chargers, voltage converter DCDC, and other related integrated products) will also have huge market demand in the future. Nowadays, as labor costs are continuously rising; in order to ensure stable product quality and consistency in production, how to automatically manufacture power conversion modules, such as OBC charging modules, has become an inevitable trend in this field.

Currently, pursuing a lightweighting of automotive components has become a goal in the industry. Consequently, a size of OBC charging modules is gradually shrinking, and a large number of circuit components and electromagnetic devices are integrated inside an OBC charging module. However, for automatic manufacture of OBC charging modules, there is still a possibility of further optimizing structures and methods for installing such circuit components and electromagnetic devices. A traditional OBC charging module typically has a filtering mainboard and a power mainboard arranged with respect to each other up and down inside a casing, wherein a size of the filtering mainboard matches that of the power mainboard and the filtering mainboard is arranged above the power mainboard. This conventional arrangement where the filtering mainboard and the power mainboard are disposed separately, causes an increase in sizes of filtering circuit boards and a decrease in power density of OBC charging modules. In addition, such an arrangement complicates internal heat dissipation structures of OBC charging modules, and degrades heat dissipation effects of power device. In addition, for OBC charging modules employing such an arrangement, it is necessary to wire and assemble multiple power connectors with power devices in various positions separately inside the casing on the top and bottom of the casing, leading to relative decentralization of electrical distribution for OBC charging modules, which is unfavorable to automatically assembling OBC charging modules.

### Summary of the Invention

In order to solve the problem existing in the prior art that an arrangement where a filtering mainboard and a power mainboard are disposed separately, causes an increase in sizes of filtering circuit boards and a decrease in power density of OBC charging modules, the present invention proposes a power conversion module with high integration and power density, and a vehicle-mounted charger using same.

In order to solve the above problems, the technical scheme of the present invention is as follows:
the present invention provides a power conversion module, including a casing, and a spatial water channel, a power mainboard, an input terminal, a signal terminal, a LVDC terminal, and an output terminal each disposed on the casing, the input terminal, the signal terminal, the LVDC terminal, and the output terminal are arranged on an the same side of the casing, and the input terminal and the output terminal are respectively at two ends on the same side of the casing opposite to each other;
the power conversion module further comprises: an input filtering circuit board and an output filtering circuit board, the input filtering circuit board and the output filtering circuit board are respectively arranged on two adjacent sides of the casing where the input terminal and the output terminal are disposed, and are electrically connected to the input terminal and the output terminal, respectively;
the power mainboard is disposed at the top of the casing and electrically connected respectively to the input filtering circuit board and the output filtering circuit board.

Preferably, the spatial water channel is set in the middle of the casing and lies between the input filtering circuit board and the output filtering circuit board, and a water inlet nozzle and a water outlet nozzle of the spatial water channel are set on the same side of the casing where the input terminal, the signal terminal, the LVDC terminal, and the output terminal are disposed.

Further, the power conversion module further comprises: a first shielding cover arranged between the input filtering circuit board and the power mainboard and a second shielding cover arranged between the output filtering circuit board and the power mainboard.

Preferably, the signal terminal and the LVDC terminal lie between the input terminal and the output terminal, and the signal terminal and the LVDC terminal are arranged one above another;
the water inlet nozzle lies between the input terminal and the LVDC terminal, and the water outlet nozzle lies between the output terminal and the LVDC terminal.

Further, the power conversion module further comprises a planar water channel disposed at the bottom of the casing, and a plurality of adhesive filling cavities are formed among the spatial water channel, the casing, and the planar water channel, and a heating element of either the input filtering circuit board or the output filtering circuit board is accommodated in a corresponding adhesive filling cavity.

Preferably, the input filtering circuit board and the output filtering circuit board are electrically connected to the power mainboard respectively through a power connection copper column and a signal connection copper pin.

Preferably, the input terminal is electrically connected to the input filtering circuit board through a terminal pin and the output terminal is electrically connected to the output filtering circuit board though a terminal pin.

Preferably, the input terminal is electrically connected to a terminal post of the input filtering circuit board through an adapter cable and the output terminal is electrically connected to a terminal post of the output filtering circuit board through an adapter cable.

Preferably, the input filtering circuit board is an AC input filtering circuit board, and the output filtering circuit board is an HV output filtering circuit board, and the input terminal is an AC input terminal, and the output terminal is an HV output terminal.

The present invention further provides an on-board charger, the on-board charger uses the power conversion module as above-mentioned.

Compared with the prior art, in the present invention, by way of dividing the filtering mainboard into an input filtering circuit board and an output filtering circuit board, it is possible to reduce sizes and installation areas of filtering circuit boards and increase a power density of the entire device; in addition, by way of adding a partition in the middle of the casing, dividing the interior of the casing into an upper electrical distribution space and a lower electrical distribution space, disposing a planar water channel and a spatial water channel at the center of the bottom of the partition, setting a adhesive filling cavity connected to the spatial water channel between the spatial water channel and two sides of the casing respectively, attaching a auxiliary power circuit board vertically on a water channel wall of the spatial water channel, and installing an auxiliary filtering circuit board at the bottom of each adhesive filling cavity between the spatial water channel and the two sides of the casing, it is possible to simplify the heat dissipation structure and improve the cooling effect, on the premise of maintaining the installation arrangement of the auxiliary power circuit board, the AC auxiliary filtering circuit board, and the HV auxiliary filtering circuit board to make an decrease in sizes of filtering circuit boards and an increase in power density. In addition, by way of connecting an AC input filtering circuit board and a HV output filtering circuit board to an electrical distribution board by means of a bundle of wire passing through the partition, and directly connecting a power connector preset on an outside of the casing corresponding to the upper electrical distribution space to a connection point corresponding to the electrical distribution board by means of a bundle of wire, it is possible to enlarge installation space of the electrical distribution board, make output positions of each power connectors flexible, and improve output compatibility of an entire vehicle.

### Brief Description of the Drawings

To describe the technical solutions in the embodiments of the present invention more clearly, the following briefly introduces the accompanying drawings required for describing the embodiments. Apparently, the accompanying drawings in the following description show merely some embodiments of the present invention, and a person of ordinary skill in the art may still derive other drawings from these accompanying drawings without creative efforts.
Fig. 1 is a diagram depicting an overall assembly structure in an embodiment of the power conversion module provided by the present invention.
Fig. 2 is a diagram depicting an input filtering circuit board in an embodiment of the power conversion module provided by the present invention.
Fig. 3 is a diagram depicting an output filtering circuit board in an embodiment of the power conversion module provided by the present invention.
Fig. 4 is a top view of the power conversion module in Fig. 1 without the top cover plate, the first shielding cover, the second shielding cover, and the power mainboard.
Fig. 5 is a diagram depicting a state of the power conversion module in Fig. 4 with the first shielding cover and the second shielding cover.
Fig. 6 is an exploded view of the power mainboard of the power conversion module in Fig. 1, without the top cover plate.
Fig. 7 is an overall exploded view of the power conversion module in Fig. 1.
Fig. 8 is a diagram of the power conversion module in Fig. 4 without the input filtering circuit board and the output filtering circuit board.
Fig. 9 is a cross-sectional view of the power conversion module in Fig. 1.
Fig. 10 is a diagram of the power conversion module in Fig. 5, where an adapter cable has been replaced with a terminal solder pin.

Where, 1-casing; 11-adhesive filling cavity; 12-upper cover plate; 2-spatial water channel; 21-water inlet nozzle; 22-water outlet nozzle; 3-power mainboard; 4-input terminal; 41-adapter cable; 42-terminal pin; 5-signal terminal; 6-output terminal; 7-LVDC terminal; 8-input filtering circuit board; 81-first shielding cover; 82-terminal post; 9-output filtering circuit board; 91 second shielding cover; 92-power connection copper column; 93-signal connection copper pin.

### Detailed Description of Embodiments

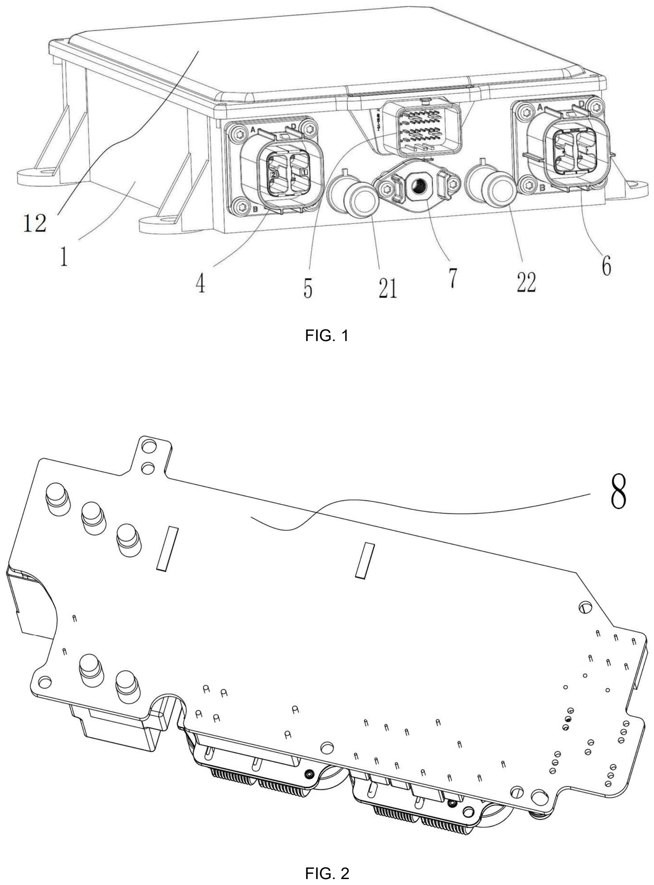

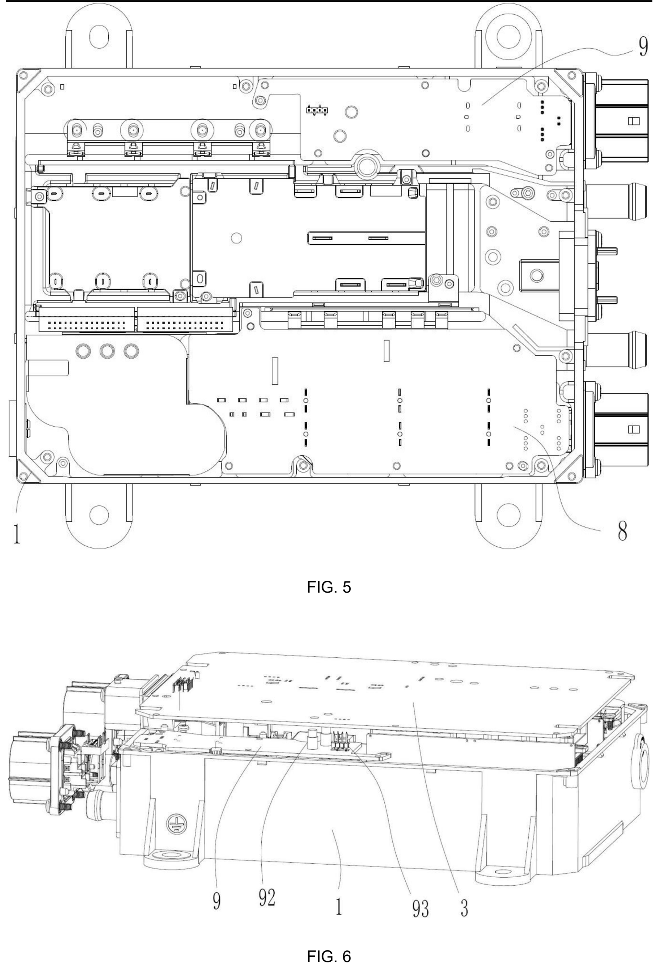

In order to make the technical problem to be solved by the present invention, the technical solution, and the beneficial effect clearer, we shall further describe the present invention in detail in combination with Figs. 1-10 and embodiments.

With reference to Figs. 1-7, the power conversion module provided by the present invention includes: a casing 1, a spatial water channel 2 and a power mainboard 3 both disposed inside the casing 1, and an input terminal 4, a signal terminal 5, a LVDC terminal 7, and an output terminal 6 each disposed outside the casing 1, wherein the input terminal 4, the signal terminal 5, the LVDC terminal 7 (low-voltage DC terminal), and the output terminal 6 are arranged on the same side of the casing 1, and the input terminal 4 and the output terminal 6 are respectively at two ends on the same side of the casing 1 opposite to each other.

With reference to Figs. 2-7 and 9, the power conversion module further includes: an input filtering circuit board 8 and an output filtering circuit board 9, wherein the input filtering circuit board 8 and the output filtering circuit board 9 are respectively arranged on two adjacent sides of the casing 1 where the input terminal 4 and the output terminal 6 are disposed (that is, the input filtering circuit board 8 and the output filtering circuit board 9 are respectively arranged on the left and right sides of the casing 1), and are electrically connected to the input terminal 4 and the output terminal 6, respectively; the power mainboard 3 is disposed at the top of the casing 1 and electrically connected respectively to the input filtering circuit board 8 and the output filtering circuit board 9.

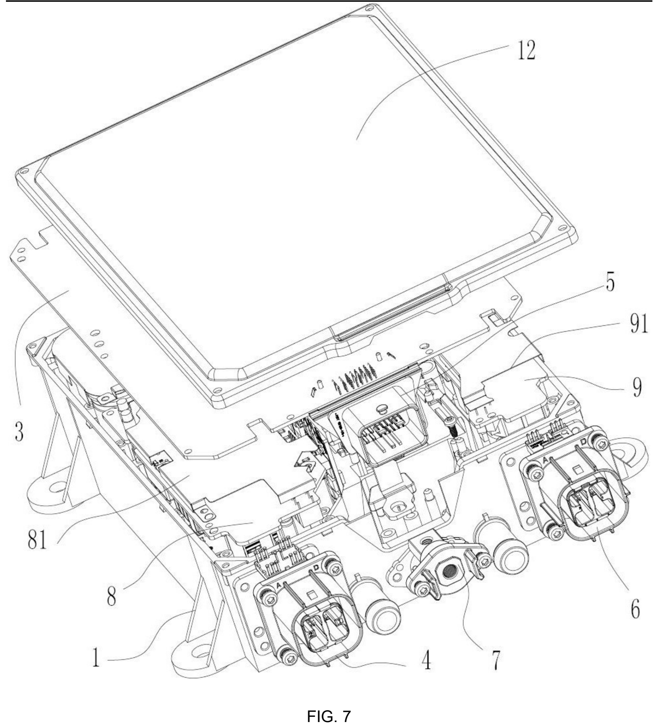

With reference to Figs. 1 and 7, in this embodiment, the casing 1 is a cuboid, and has an upper cover plate 12, which is disposed on the top end of the power mainboard 3, and encloses an internal space of the casing 1. The spatial water channel 2 is set in the middle of the casing 1, lies between the input filtering circuit board 8 and the output filtering circuit board 9, and extends axially along the casing 1, and a water inlet nozzle 21 and a water outlet nozzle 22 of the spatial water channel 2 are set on the same side of the casing 1 where the input terminal 4, the signal terminal 5, the LVDC terminal 7, and the output terminal 6 are disposed, and the water inlet nozzle 21 and the water outlet nozzle 22 are respectively communicated with a water inlet and a water outlet corresponding to a pair of water channel walls of the spatial water channel 2.

With reference to Figs. 1 and 7, in this embodiment, the signal terminal 5 and the LVDC terminal 7 lie between the input terminal 4 and the output terminal 6, and the signal terminal 5 and the LVDC terminal 7 are arranged one above another.

With reference to Figs. 1 and 7, in this embodiment, the water inlet nozzle 21 lies between the input terminal 4 and the LVDC terminal 7, and the water outlet nozzle 22 lies between the output terminal 6 and the LVDC terminal 7. In another embodiment, the water inlet nozzle 21 lies between the output terminal 6 and the LVDC terminal 7, and the water outlet nozzle 22 lies between the input terminal 4 and the LVDC terminal 7, in other words, it is possible to transpose the positions of the water inlet nozzle 21 and the water outlet nozzle 22, and reverse an inlet/outlet direction of the spatial water channel 2.

**In** order to solve the technical problem existing in the prior art that an arrangement where a filtering mainboard and a power mainboard 3 are disposed separately, causes an increase in sizes of filtering circuit boards and a decrease in power density, in the present invention, by way of dividing the filtering mainboard into an input filtering circuit board 8 and an output filtering circuit board 9, it is possible to reduce sizes and installation areas of filtering circuit boards and increase power density of the entire device; in addition, by way of arranging the input terminal 4, the signal terminal 5, the LVDC terminal 7, the output terminal 6, the water inlet nozzle 21, and the water outlet nozzle 22 on the same side of the casing 1, and arranging the input filtering circuit board 8 and the output filtering circuit board 9 respectively on two adjacent sides of the casing 1 where the input terminal 4 and the output terminal 6 are disposed, it is possible to optimize power distribution layout of the power conversion module, enlarge installation space of the electrical distribution, and make arrangement of each power connector flexible; in this way, the output terminals 6 of each power connector can be electrically connected to a corresponding filtering circuit board on the same side of the casing 1 by means of a bundle of wire or a weldable connector, thereby posing low requirements for positioning each output, improving output compatibility of an entire vehicle, and making it easy to automatically install bundles of wire for an entire vehicle using this power conversion module and the onboard charger.

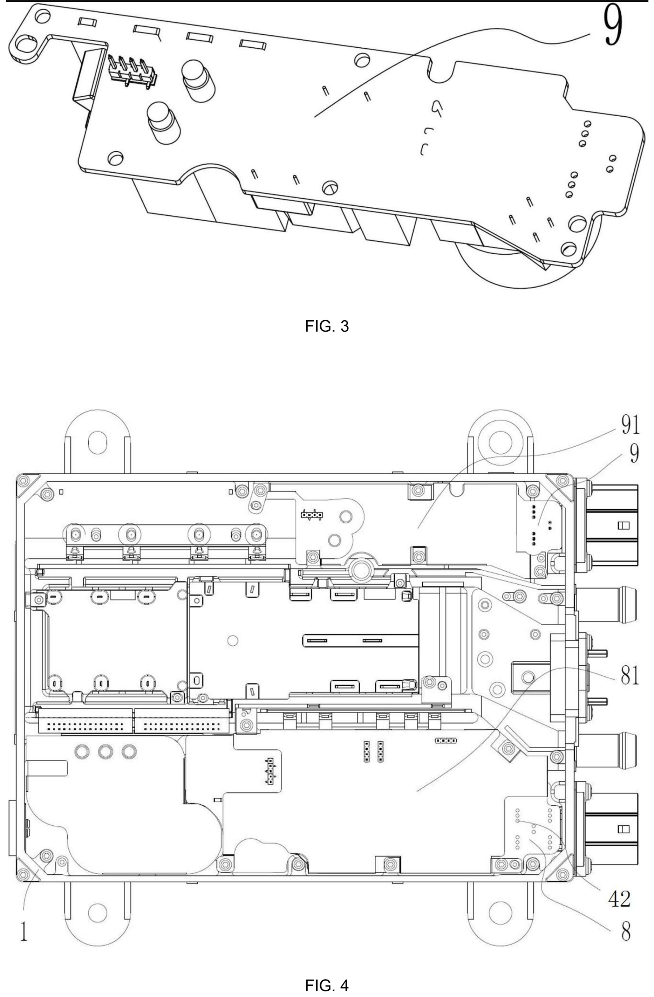

With reference to Figs. 4 and 7, in this embodiment, the power conversion module further includes: a first shielding cover 81 arranged between the input filtering circuit board 8 and the power mainboard 3 and a second shielding cover 91 arranged between the output filtering circuit board 9 and the power mainboard 3, so as to form an EMC shielding cavity respectively between the input filtering circuit board 8 and the power mainboard 3, and between the output filtering circuit board 9 and the power mainboard 3, thereby improving electromagnetic shielding and resistance to electromagnetic interference between either the input filtering circuit board 8 or the output filtering circuit board 9 and the power mainboard 3.

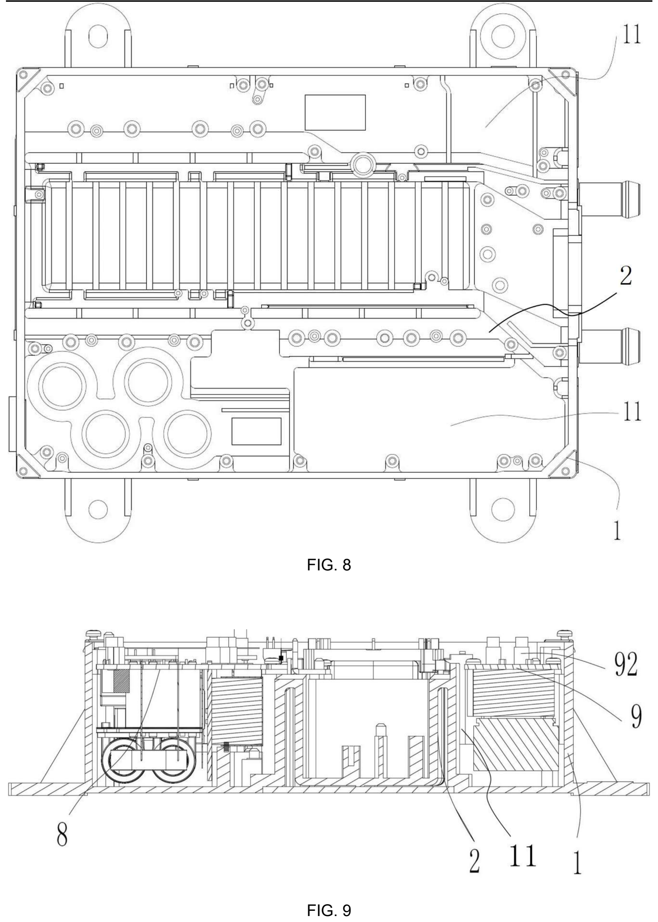

With reference to Figs. 8 and 9, in this embodiment, the power conversion module further includes a planar water channel (not shown in the figures) disposed at the bottom of the casing 1 and communicated the spatial water channel 2, wherein a plurality of adhesive filling cavities 11 are formed among the spatial water channel 2, the casing 1, and the planar water channel, and each adhesive filling cavity 11 is preferably made by die casting. A heating element of either the input filtering circuit board 8 or the output filtering circuit board 9 is accommodated in a corresponding adhesive filling cavity 11. By way of injecting thermally conductive adhesives into each adhesive filling cavity 11, it is possible to connect the heating element of either the input filtering circuit board 8 or the output filtering circuit board 9 with the spatial water channel 2 and the planar water channel and carry away heat generated by the heating element by the coolant in the spatial water channel 2 and the planar water channel, thereby realizing heat dissipation for filtering components.

With reference to Figs. 2-5, 6 and 9, in this embodiment, the casing 1 (preferably a wall of the spatial water channel 2 and a cavity wall of each adhesive filling cavity 11, or inside each adhesive filling cavity 11) is provided with a limiter for mounting the input filtering circuit board 8 and the output filtering circuit board 9 (not shown in the figures), and a positioner for aligning and fitting with the limiter is respectively on the input filtering circuit board 8 and the output filtering circuit board 9 (not shown in the figures). The positioner and the limiter may be respectively a positioning pin and a limiting hole, or a positioning hole and a limiting pin, or a combination of a positioning hole and a limiting hole with screws, or a positioning pin with a mounting hole and a limiting hole with screws, so as to enable the input filtering circuit board 8 and output filtering circuit board 9 to align and fit with each other.

With reference to Figs. 7 and 9, in this embodiment, the input filtering circuit board 8, the output filtering circuit board 9, and power mainboard 3 are arranged parallel to each other. The input filtering circuit board 8 and the output filtering circuit board 9 are preferably arranged on the same plane.

In view of the problem that installation and arrangement of the existing power conversion module leads to a complex heat dissipation structure and a limited heat dissipation effect, in the present the invention, by way of setting an adhesive filling cavity 11 connected to the spatial water channel 2 between the spatial water channel and two sides of the casing 1 respectively, and accommodating the heating component of either the input filtering circuit board 8 or the output filtering circuit board 9 in the adhesive filling cavity 11, it is possible to enable the power devices on the input filtering circuit board 8 and the output filtering circuit board 9 to achieve heat dissipation in contact with the water channel walls through thermally conductive adhesives, simplify the heat dissipation structure and improve the cooling effect, on the premise of maintaining the installation arrangement of the input filtering circuit board 8 and the output filtering circuit board 9; thereby keeping each power device and each filtering device at an ideal operation temperature.

With reference to Figs. 2, 3, 6 and 9, in this embodiment, the input filtering circuit board 8 and the output filtering circuit board 9 are electrically connected to the power mainboard 3 respectively through a power connection copper column 92 and a signal connection copper pin 93. In other embodiments, the input filtering circuit board 8 and the output filtering circuit board 9 can also be electrically connected to the power mainboard 3 through metal terminals.

With reference to Fig. 4, in this embodiment, the input terminal 4 is electrically connected to the input filtering circuit board 8 through terminal pins 42 and the output terminal 6 is electrically connected to the output filtering circuit board 9 through terminal pins 42.

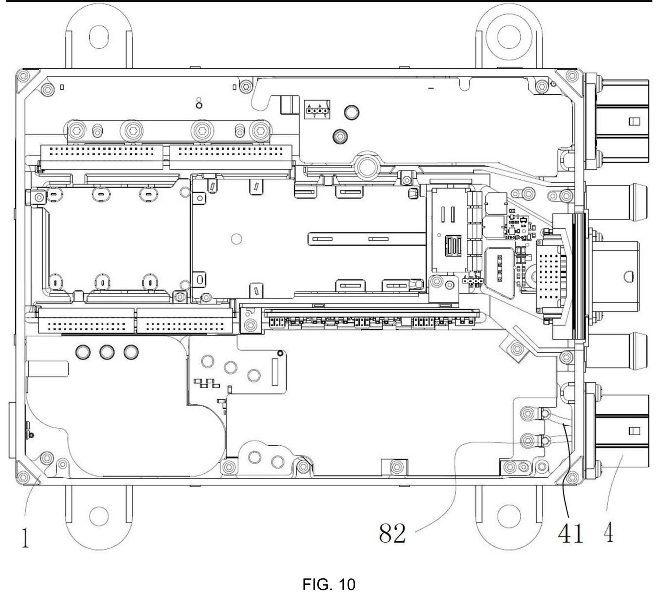

With reference to Fig. 10, in this embodiment, the input terminal 4 is electrically connected to a terminal post 82 of the input filtering circuit board 8 through adapter cables 41 and the output terminal 6 is electrically connected to a terminal post 82 of the output filtering circuit board 9 through adapter cables 41. In other words; by way of replacing a weldable connector with a plug-in connector, it just needs to correspondingly change terminal connection structures on the input filtering circuit board 8 and the output filtering circuit board 9, thereby improving the compatibility and adaptability of the power conversion module with different power connector models and specifications.

In this embodiment, the input filtering circuit board 8 is an AC input filtering circuit board 8, the output filtering circuit board 9 is an HV output filtering circuit board 9, the input terminal 4 is an AC input terminal 4, and the output terminal 6 is an HV output terminal 6.

The present invention further provides an on-board charger that uses the above-mentioned power conversion module. In this embodiment (not shown in the figures), the on-board charger further includes a vent valve and a grounding point each disposed on the casing 1, a plurality of mounting feet disposed at the bottom end of the casing 1.

The above description is merely a preferred embodiment of the present invention and is not supposed to pose any limitations on the present invention. Any modifications, equivalent substitutions, and improvements made within the essence and principle of the present invention should fall within the protection scope of the invention.

## Claims

1. A power conversion module, including a casing (1), and a spatial water channel (2), a power mainboard (3), an input terminal (4), a signal terminal (5), a LVDC terminal (7), and an output terminal (6) each disposed on the casing (1), wherein the input terminal (4), the signal terminal (5), the LVDC terminal (7), and the output terminal (6) are arranged on the same side of the casing (1), and the input terminal (4) and the output terminal (6) are respectively at two ends on the same side of the casing (1) opposite to each other;
the power conversion module further comprises: an input filtering circuit board (8) and an output filtering circuit board (9), the input filtering circuit board (8) and the output filtering circuit board (9) are respectively arranged on two adjacent sides of the casing (1) where the input terminal (4) and the output terminal (6) are disposed, and are electrically connected to the input terminal (4) and the output terminal (6), respectively; the power mainboard (3) is disposed at the top of the casing (1) and electrically connected respectively to the input filtering circuit board (8) and the output filtering circuit board (9).

2. The power conversion module according to claim 1, wherein the spatial water channel (2) is set in the middle of the casing (1) and lies between the input filtering circuit board (8) and the output filtering circuit board (9), and a water inlet nozzle (21) and a water outlet nozzle (22) of the spatial water channel (2) are set on the same side of the casing (1) where the input terminal (4), the signal terminal (5), the LVDC terminal (7), and the output terminal (6) are disposed.

3. The power conversion module according to claim 2, wherein the power conversion module further comprises: a first shielding cover (81) arranged between the input filtering circuit board (8) and the power mainboard (3) and a second shielding cover (91) arranged between the output filtering circuit board (9) and the power mainboard (3).

4. The power conversion module according to claim 2, wherein the signal terminal (5) and the LVDC terminal (7) lie between the input terminal (4) and the output terminal (6), and the signal terminal (5) and the LVDC terminal (7) are arranged one above another; the water inlet nozzle (21) lies between the input terminal (4) and the LVDC terminal (7), and the water outlet nozzle (22) lies between the output terminal (6) and the LVDC terminal (7).

5. The power conversion module according to claim 2, wherein the power conversion module further comprises a planar water channel disposed at the bottom of the casing (1), and a plurality of adhesive filling cavities are formed among the spatial water channel (2), the casing (1), and the planar water channel, and a heating element of either the input filtering circuit board (8) or the output filtering circuit board (9) is accommodated in a corresponding adhesive filling cavity (11).

6. The power conversion module according to any one of claims 1-5, wherein the input filtering circuit board (8) and the output filtering circuit board (9) are electrically connected to the power mainboard (3) respectively through a power connection copper column (92) and a signal connection copper pin (93).

7. The power conversion module according to any one of claims 1-5, wherein the input terminal (4) is electrically connected to the input filtering circuit board (8) through a terminal pin (42) and the output terminal (6) is electrically connected to the output filtering circuit board (9) through a terminal pin (42).

8. The power conversion module according to any one of claims 1-5, wherein the input terminal (4) is electrically connected to a terminal post (82) of the input filtering circuit board (8) through an adapter cable (41) and the output terminal (6) is electrically connected to a terminal post (82) of the output filtering circuit board (9) through an adapter cable (41).

9. The power conversion module according to any one of claims 1-5, wherein the input filtering circuit board (8) is an AC input filtering circuit board, and the output filtering circuit board (9) is an HV output filtering circuit board, and the input terminal (4) is an AC input terminal, and the output terminal (6) is an HV output terminal.

10. An on-board charger, wherein the on-board charger uses the power conversion module claimed in any one of claims 1-9.
